# FASCICULE DE BREVET EUROPEEN

(11) **EP 1 573 810 B1**
(45) Date de publication et mention de la délivrance du brevet: **30.04.2008**
(21) Numéro de dépôt: 03809991.7
(22) Date de dépôt: 16.12.2003
(51) Int. Cl.: H01L 23/544

(54) **PROCEDE DE FORMATION DE MOTIFS ALIGNES DE PART ET D'AUTRE D'UN FILM MINCE**
HERSTELLUNGSVERFAHREN VON AUSGERICHTETEN STRUKTUREN AUF BEIDEN SEITEN EINER DÜNNSCHICHT
METHOD FOR FORMING PATTERNS ALIGNED ON EITHER SIDE OF A THIN FILM

(30) Priorité: 17.12.2002 FR 0215980
(43) Date de publication de la demande: 14.09.2005
(73) Titulaire: COMMISSARIAT A L'ENERGIE ATOMIQUE, 75015 Paris (FR)
(72) Inventeur: VINET, Maud, 38140 RIVES (FR); DELEONIBUS, Simon, F-38640 CLAIX (FR); PREVITALI, Bernard, F-38100 GRENOBLE (FR); FANGET, Gilles, F-38140 Reaumont (FR)
(74) Mandataire: Poulin, Gérard
(86) Numéro de dépôt international: PCT/FR2003/050179
(87) Numéro de publication internationale: WO 2004/057671

(56) Documents cités:
- US-A- 5 013 681
- US-A- 5 436 173
- US-A- 5 952 694
- US-A1- 2002 076 853
- PATENT ABSTRACTS OF JAPAN vol. 018, no. 035 (E-1494), 19 janvier 1994 (1994-01-19) -& JP 05 267663 A (FUJITSU LTD), 15 octobre 1993 (1993-10-15)

## Description

### Domaine technique et art antérieur

L'invention concerne un procédé de formation de motifs alignés de part et d'autre d'un film mince.

L'invention s'applique plus particulièrement à la fabrication de composants et de micro-systèmes à trois dimensions tels que, par exemple, les circuits numériques de type circuits mémoire.

De façon générale, en technologie microélectronique sur semi-conducteur, des marques sont utilisées pour réaliser l'alignement de motifs (grilles de transistors, contacts métalliques, niveaux de métallisation, etc.). Ces marques sont utilisées aussi bien dans le cas de la lithographie optique que dans le cas de la lithographie électronique.

Dans le cas de la lithographie électronique, les marques d'alignement sont généralement des trous carrés de faibles dimensions (par exemple, 8µm² de surface et 800nm de profondeur) réalisés dans un oxyde d'isolation qui isole les différents composants. Elles sont lues par différence d'intensité entre les électrons rétro-diffusés par les trous et ceux rétro-diffusés par la surface.

Dans le cas de substrats de silicium sur isolant (SOI), les marques d'alignement pour la lithographie optique sont réalisées dans un substrat qui se trouve sous un oxyde enterré. Dans un premier temps, on effectue une gravure du film mince semi-conducteur qui se trouve au-dessus de l'oxyde enterré et, dans un deuxième temps, on grave l'oxyde enterré pour dégager une grande surface de substrat. Les marques sont alors gravées directement dans le substrat.

Pour former des motifs alignés sur les deux faces d'un film mince semi-conducteur, il est nécessaire de positionner les motifs réalisés sur une face par rapport aux motifs réalisés sur l'autre face.

Selon l'art connu, dans le cas de la lithographie optique, la réalisation de circuits ayant des motifs sur les deux faces d'un film de silicium actif conduit à une opération durant laquelle le substrat d'origine dans lequel les marques sont gravées est éliminé. Les marques disparaissent donc avec le substrat. Dans le cas de la lithographie électronique, les marques, réalisées sur un oxyde d'isolation, sont remplies avec de l'oxyde de planage. Au moment du retrait de l'oxyde enterré, elles sont également consommées puisque tout leur entourage est en oxyde. Dans les deux cas, les marques qui ont servi à positionner les motifs sur une première face sont totalement éliminés. Il faut alors créer de nouvelles marques pour la réalisation de motifs sur la deuxième face. Les motifs créés sur la deuxième face ne peuvent alors plus être alignés avec les motifs de la première face.

Différentes méthodes ont été proposées pour éviter cet inconvénient.

La demande brevet EP 0513684 divulgue des marques d'alignement pour réaliser des reprises de contact en face arrière d'un substrat. Pour cela, une zone de champ est gravée dans un substrat de silicium. Le substrat est ensuite recouvert d'isolant. Les marques d'alignement sont gravées dans la zone de champ alors que des trous de contact sont gravés dans la zone où les motifs doivent être formés. Une couche métallique est ensuite déposée, puis gravée, pour former les marques d'alignement et les trous de contacts. La face arrière du substrat est alors amincie jusqu'à trouver la marque d'alignement qui permet de retrouver le trou de contact. Il est alors possible de retrouver en face arrière la position de motifs réalisés en face avant. Cette technique présente cependant plusieurs inconvénients, à savoir :
- l'obligation d'utiliser des matériaux métalliques,
- l'obligation de conserver le même substrat,
- la réalisation, en face arrière, de structures essentiellement locales (c'est-à-dire situées à des endroits précis) et donc l'impossibilité d'utiliser toute la face arrière (il n'est par exemple pas possible de faire une implantation ionique).

Une autre méthode connue divulgue un alignement des circuits en trois dimensions. Cette méthode est décrite dans le brevet US 5 266 511. Au départ, on dispose de deux substrats à aligner. Sur le premier substrat, les marques d'alignement sont réalisées, par exemple au niveau des chemins de découpe. Au niveau du deuxième substrat, on réalise un trou qui correspond à la largeur du chemin de découpe, ce trou étant ensuite rempli avec une couche isolante qui est aplanie. Les deux substrats sont ensuite collés en prenant soin d'aligner le trou et le chemin de découpe à l'aide d'un microscope infrarouge. Ensuite, la face arrière du deuxième substrat est retirée jusqu'à la couche isolante qui a permis de remplir le trou et la marque d'alignement est lue avec un microscope. Un inconvénient de cette méthode est l'insuffisance de la précision de l'alignement qui est obtenu avec le microscope infrarouge (≈ 1µm).

Le brevet US 5 952 694 est également connu de l'art antérieur. Il divulgue un procédé de formation de motifs alignés de part et d'autre d'un film mince à l'aide d'une marque d'alignement.

L'invention ne présente pas les inconvénients mentionnés ci-dessus.

### Exposé de l'invention

En effet, l'invention concerne un procédé de formation de motifs alignés de part et d'autre d'un film mince déposé sur un substrat, le procédé comprenant une gravure locale du film mince pour former une première marque, caractérisé en ce qu'il comprend :
- un dépôt de première couche de motif sur le film mince, le dépôt de première couche de motif précédant ou succédant à la gravure locale du film mince,
- une première étape de lithographie pour définir un emplacement de premier motif, avec alignement de l'emplacement de premier motif par rapport à la première marque,
- une gravure locale de la première couche de motif pour former un premier motif,
- un dépôt d'une première couche de collage pour recouvrir la première marque et le premier motif,
- un retournement de la structure obtenue suite au dépôt de la première couche de collage,
- un collage de la première couche de collage sur un substrat de report,
- la suppression du substrat, et
du côté du film mince situé à l'opposé du substrat de report :
- une étape de gravure de la première couche de collage pour former une deuxième marque à l'emplacement de la première marque,
- une étape de dépôt d'une deuxième couche de motif,
- une deuxième étape de lithographie pour définir un emplacement de deuxième motif, avec alignement de l'emplacement de deuxième motif par rapport à la deuxième marque, et
- une étape de gravure de la deuxième couche de motif pour former le deuxième motif.

Selon une caractéristique supplémentaire du procédé selon l'invention, le collage de la première couche de collage est effectué à l'aide d'une deuxième couche de collage qui recouvre le substrat de report.

Selon encore une caractéristique supplémentaire du procédé de l'invention, les première et deuxième couches de collage étant des couches d'oxyde, le collage est un collage moléculaire.

Selon encore une caractéristique supplémentaire du procédé de l'invention, la deuxième marque est transférée dans le substrat de report.

Selon encore une caractéristique supplémentaire du procédé de l'invention, la gravure locale des première et deuxième couches de motif est une gravure plasma.

Selon encore une caractéristique supplémentaire du procédé de l'invention, la première et la deuxième couches de motif sont des couches de silicium poly-cristallin, ou de métal, ou de nitrure, ou de silicium, ou de silice, ou de matériau Hik.

Selon encore une caractéristique supplémentaire du procédé de l'invention, le film mince est un film mince semi-conducteur.

Selon encore une caractéristique supplémentaire du procédé de l'invention, le film mince semi-conducteur est un film de silicium, d'arséniure de gallium ou de SiGe.

Selon encore une caractéristique supplémentaire du procédé de l'invention, la gravure locale du film mince semi-conducteur est une gravure chimique humide ou une gravure plasma anisotrope.

Selon encore une caractéristique supplémentaire de l'invention, le procédé comprend une étape pour former une première couche d'oxyde de grille entre le film mince semi-conducteur et la première couche de motif et l'étape de dépôt de la deuxième couche de motif- est précédée du dépôt d'une deuxième couche d'oxyde de grille sur le film mince semi-conducteur.

Selon encore une caractéristique supplémentaire du procédé de l'invention, le premier motif et le deuxième motif sont des grilles de transistor.

Selon encore une caractéristique supplémentaire du procédé de l'invention, le film mince est un film mince métallique.

Selon encore une caractéristique supplémentaire du procédé de l'invention, le film mince métallique est un film de TiN ou de W.

Selon encore une caractéristique supplémentaire du procédé de l'invention, la première et la deuxième étapes de lithographie sont des étapes de lithographie optique ou électronique.

Selon encore une caractéristique supplémentaire de l'invention, le procédé comprend la formation d'une couche tampon enterrée entre le film mince et le substrat.

Selon encore une caractéristique supplémentaire du procédé de l'invention, la couche tampon enterrée est une couche de SiO₂, ou de SiGe, ou de Ni₃N₄.

### Brève description des figures

D'autres caractéristiques et avantages de l'invention apparaîtront à la lecture d'un mode de réalisation préférentiel fait en référence aux figures jointes parmi lesquelles :
- les figures 1 à 11 représentent différentes étapes d'un premier mode de réalisation du procédé de formation de motifs alignés selon l'invention ;
- les figures 12 et 13 représentent une variante du premier mode de réalisation représenté aux figures 1 à 11 ;
- les figures 14 à 20 représentent différentes étapes d'un deuxième mode de réalisation du procédé d'alignement de motifs selon l'invention.

Sur toutes les figures, les mêmes repères désignent les mêmes éléments.

### Description détaillée de modes de réalisation de l'invention

L'invention sera plus particulièrement décrite dans le cas d'un alignement de grilles de transistors situées de part et d'autre d'un film mince de silicium.

De façon plus générale, comme cela a déjà été mentionné ci-dessus, l'invention concerne l'alignement de tout type de motifs (grilles, sources, drains, interconnexions métalliques, contacts, etc.) situés de part et d'autre d'un film mince semi-conducteur ou métallique.

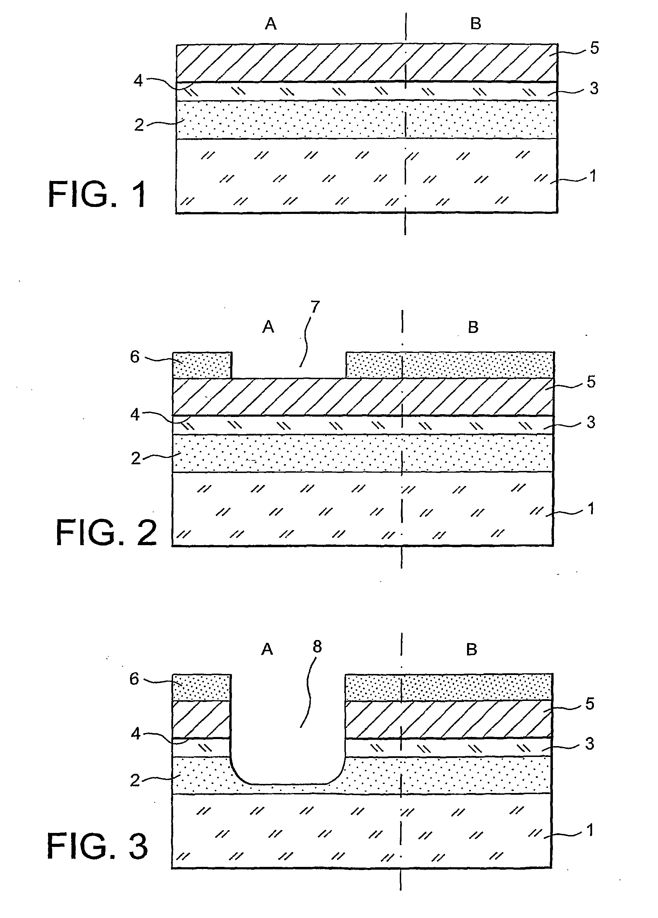

Les figures 1 à 11 représentent différentes étapes d'un premier mode de réalisation du procédé de formation de motifs alignés selon l'invention.

La figure 1 représente une structure de type SOI (SOI pour « Silicon On Insulator ») constitué d'un empilement de couches déposées sur un substrat 1, à savoir : une couche tampon enterrée 2, une couche mince de silicium 3, une première couche d'oxyde de grille 4 et une première couche de motif 5. Deux zones peuvent être distinguées dans la structure SOI : une première zone A dans laquelle vont être réalisées les marques et une deuxième zone B dans laquelle vont être réalisés les motifs alignés avec les marques.

La première couche de motif 5 présente une sélectivité de gravure chimique par rapport à l'oxyde de silicium. Comme cela apparaîtra ultérieurement, la couche 5 est la couche dans laquelle le premier motif est formé. De façon générale, la première couche de motif 5 peut être, par exemple, une couche de silicium poly-cristallin, de métal, de nitrure de silicium, ou d'isolant de grille surmontée d'un empilement de couches de grille.

Une couche de résine 6 est tout d'abord déposée sur la première couche de motif 5. La couche de résine 6 est localement gravée pour faire apparaître, dans la zone A, une cavité 7 qui définit la position d'une marque d'alignement (cf. figure 2).

Une gravure plasma anisotrope de la couche 5, de la première couche d'oxyde de grille 4 et du film mince de silicium 3 est alors effectuée pour former une marque 8. Cette étape de gravure plasma anisotrope est suivie par une étape de gravure chimique humide ou de gravure plasma anisotrope sélective par rapport au silicium qui transfère la marque 8 jusque dans la couche tampon enterrée 2 (cf. figure 3). La couche de résine 6 qui appartient à la partie B de la structure SOI permet de protéger la couche 5 de la partie B lors de l'opération de gravure.

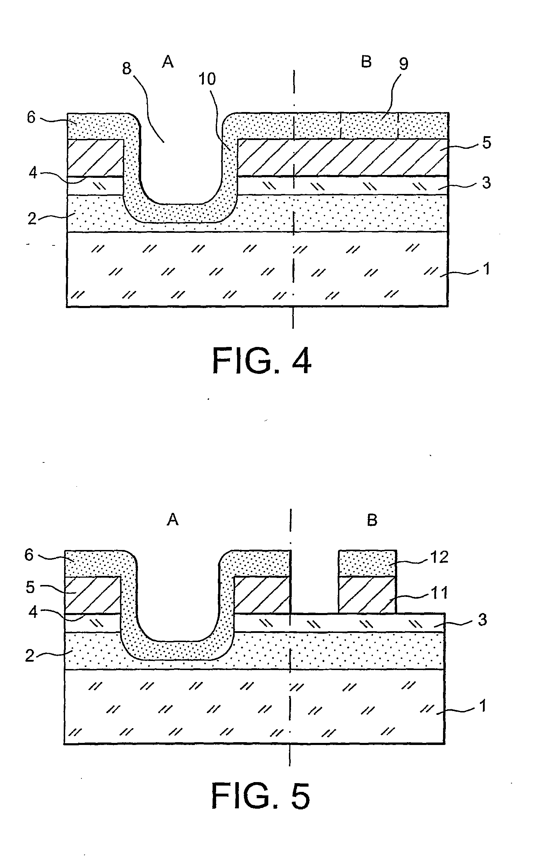

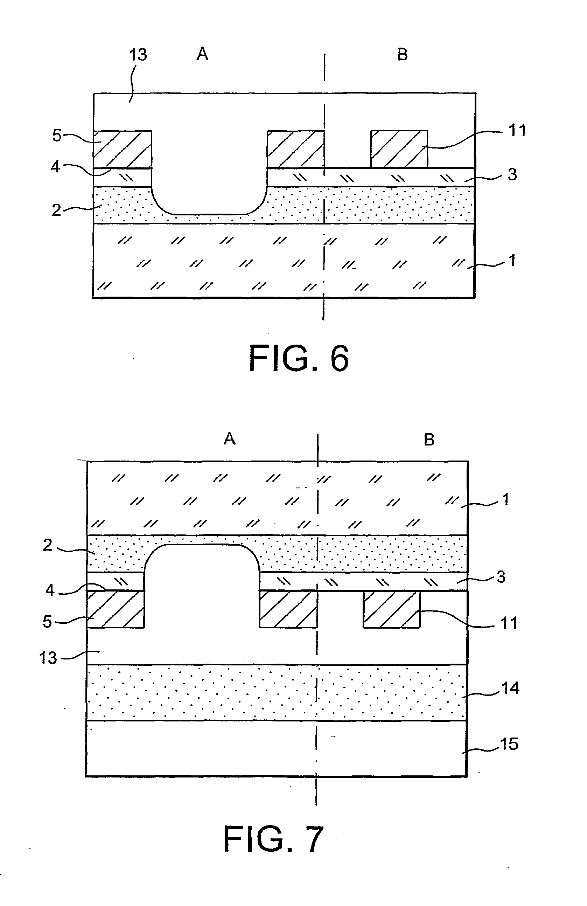

Une couche de résine 10 est ensuite déposée pour remplir partiellement la marque 8 (cf. figure 4). Une étape de lithographie optique ou électronique permet alors de définir l'emplacement 9 d'une première grille. Durant cette étape de lithographie, l'emplacement 9 de la première grille est aligné sur la marque 8. La couche de résine 6 située dans la partie B de la structure est ensuite insolée par un procédé de lithographie et révélée pour définir l'endroit des motifs à graver. La couche 5 est ensuite gravée, par exemple, par gravure plasma, aux endroits où la résine a disparu pour réaliser une première grille 11 recouverte d'une couche de résine 12 (cf. figure 5). La couche de résine 12 est ensuite éliminée. Une première couche d'oxyde de collage 13 est alors déposée, par exemple par pulvérisation ou par dépôt chimique en phase vapeur, communément appelé dépôt CVD (CVD pour « Chemical Vapour Deposition »), pour combler l'espace qui définit la marque ainsi que les zones gravées qui entourent la grille (cf. figure 6). La première couche d'oxyde de collage 13 est ensuite aplanie. La structure obtenue suite à l'opération de dépôt et de planage de la couche 13 est alors retournée et la face libre de la couche 13 est collée, par collage moléculaire (oxyde sur oxyde), sur une deuxième couche d'oxyde de collage 14 qui recouvre un substrat de report 15 (cf. figure 7).

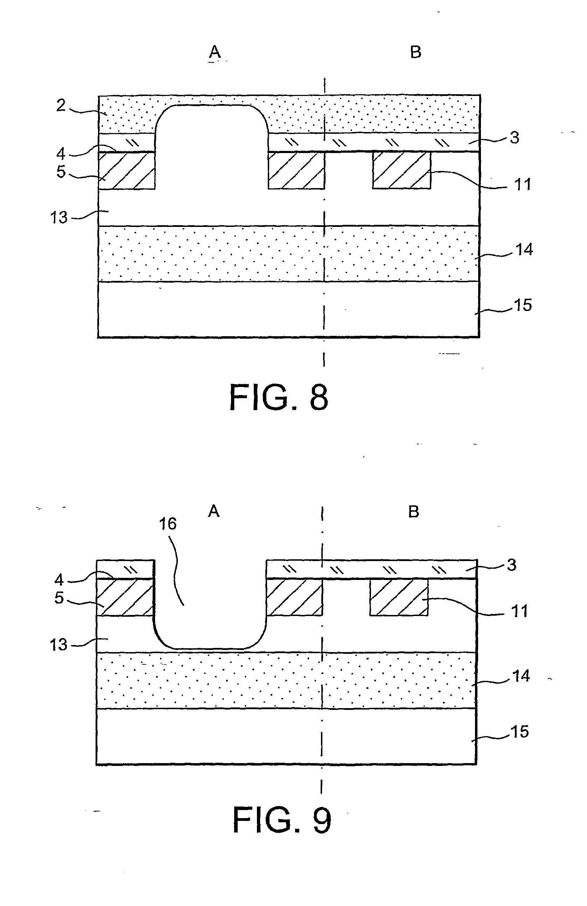

Le substrat de silicium 1 est ensuite éliminé par rectification puis attaque chimique, par exemple par attaque TMAH (TMAH pour « Tétra Methyl Amonium Hydroxyde »), avec arrêt sur la couche tampon enterrée 2 (cf. figure 8). La couche tampon 2 est ensuite éliminée par voie humide et la première couche d'oxyde de collage 13 est gravée. Une marque 16 est ainsi réalisée au même endroit que la marque 8 (cf. figure 9).

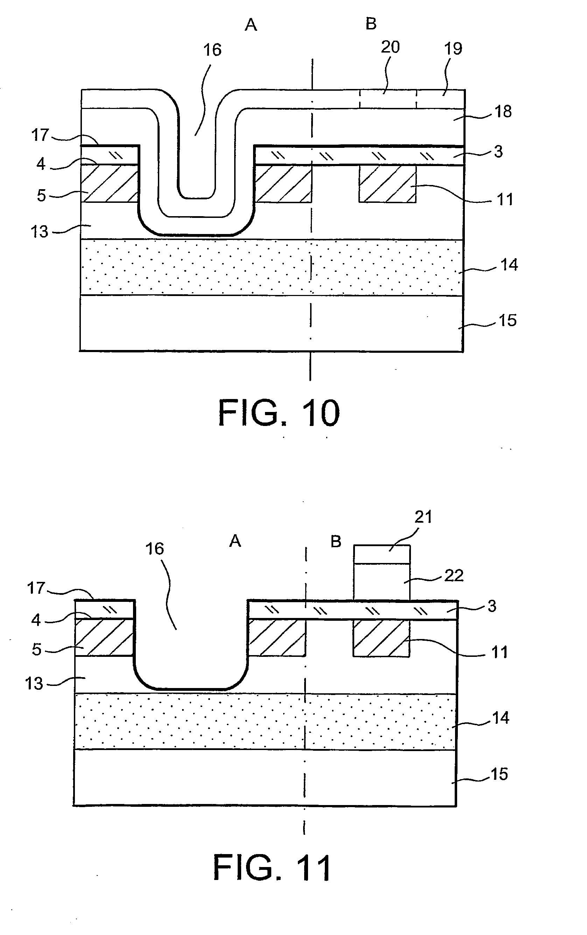

La couche de silicium 3 et l'intérieur de la marque 16 sont ensuite recouverts, successivement, d'une deuxième couche d'oxyde de grille 17, d'une deuxième couche de motif 18 et d'une couche de résine 19 (cf. figure 10). Comme cela apparaîtra ci-dessous, la couche de motif 18 est la couche dans laquelle le deuxième motif est formé. Une étape de lithographie optique ou électronique permet ensuite de définir l'emplacement 20 d'une deuxième grille par rapport à la marque 16. La marque 16 étant réalisée au même endroit que la marque 8, l'emplacement de la deuxième grille se trouve ainsi aligné avec l'emplacement de la première grille. La couche de résine 19 et la deuxième couche de motif 18 sont ensuite gravées, par exemple, par gravure plasma, pour réaliser la deuxième grille 22 recouverte d'une couche de résine 21 (cf. figure 11).

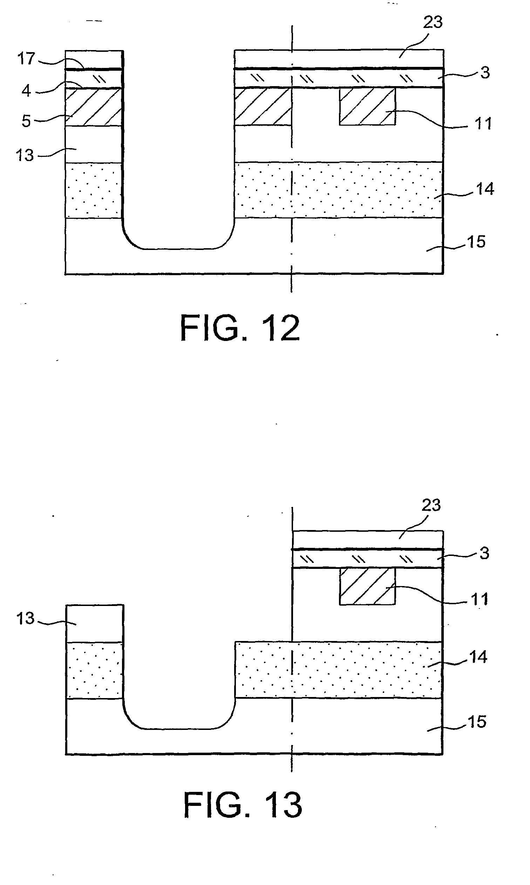

Les figures 12 et 13 représentent une variante du procédé représenté aux figures 1 à 11.

Selon cette variante, lors de la formation de la deuxième marque 16, cette dernière est transférée dans le substrat de report 15, comme cela apparaît sur la figure 12. Le film mince de silicium 3 sert alors de masque à une gravure anisotrope de l'oxyde par plasma sélective par rapport au silicium. Ensuite, l'oxyde définit un masque pour la gravure anisotrope du silicium du substrat de report, la partie B sur laquelle est réalisée la grille étant protégée par une couche de résine 23 lors de cette étape (cf. figure 13).

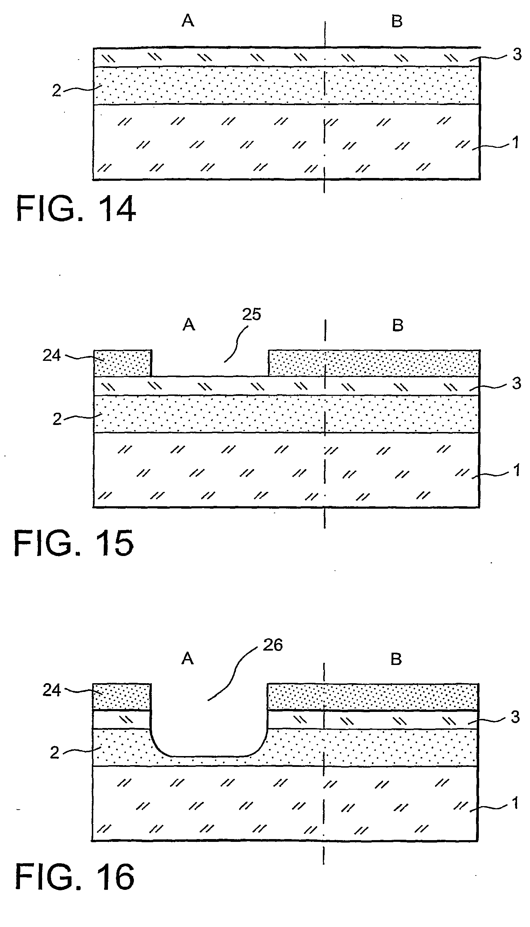

Les figures 14 à 20 représentent différentes étapes d'un deuxième mode de réalisation du procédé d'alignement de motifs selon l'invention. Selon ce deuxième mode de réalisation, la formation de la première marque est effectuée avant le dépôt de la première couche de motif.

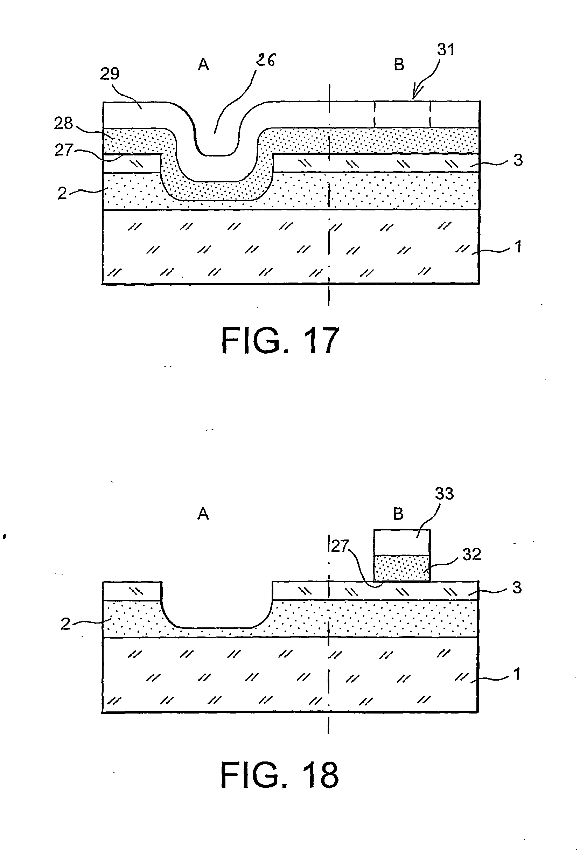

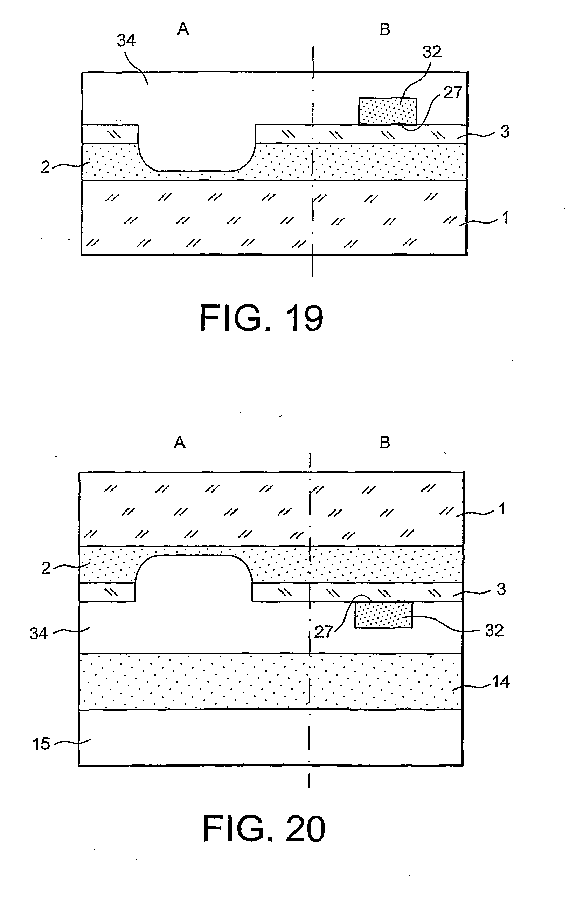

La structure de départ est alors constituée du substrat 1, de la couche tampon 2 et de la couche mince 3 (cf. figure 14). Un couche de résine 24 est tout d'abord déposée sur la couche mince 3 et une gravure de la couche de résine 24 fait apparaître la position 25 de la première marque (cf. figure 15). La couche mince 3 et la couche tampon enterrée 2 sont gravées pour former la première marque 26 (cf. figure 16). La couche de résine 24 est alors supprimée et une couche d'oxyde de grille 27, une première couche de motif 28 et une couche de résine 29 sont successivement déposées sur la structure obtenue après formation de la première marque 26 (cf. figure 17). Une étape de lithographie optique ou électronique permet de définir l'emplacement 31 d'une première grille (cf. figure 17). Durant l'étape de lithographie, l'emplacement 31 de la première grille est aligné sur la marque 26. Une première grille 32 recouverte d'une couche de résine 33 est alors formée (cf. figure 18). La couche de résine 33 est ensuite éliminée et une première couche d'oxyde de collage 34 est déposée et aplanie (cf. figure 19). La structure obtenue est alors retournée et la face libre de la couche 34 est collée par collage moléculaire (oxyde sur oxyde) sur une deuxième couche d'oxyde de collage 14 qui recouvre un substrat de report 15 (cf. figure 20).

La formation de la deuxième marque s'effectue ensuite comme représenté aux figures 8 à 11, avec également la variante relative au transfert de la deuxième marque dans le substrat de report, comme représenté aux figures 12 et 13. Les figures représentatives de la formation de la deuxième marque et du transfert de la deuxième marque dans le substrat de report n'ont pas été représentées afin de ne pas alourdir inutilement la description.

Un avantage du deuxième mode de réalisation de l'invention est la possibilité d'utiliser la première marque pour réaliser des motifs à la fois dans le film mince et dans la première couche de motif. Il est alors possible de gagner en précision d'alignement des motifs les uns par rapport aux autres. A titre d'exemple non limitatif, dans le cas où le motif dans le film mince est une zone active de transistor et où la première couche de motif est la couche de grille du transistor, le fait de gagner en précision d'alignement permet de réduire les résistances d'accès, notamment dans le cas de transistors étroits, puisqu'il est alors possible de diminuer la marge sur les dimensions de la zone active qui est très résistive.

## Revendications

1. Procédé de formation de motifs (11, 22) alignés de part et d'autre d'un film mince (3) déposé sur un substrat (1), le procédé comprenant:
- une gravure locale du film mince (3) pour former une première marque (8, 26),
- un dépôt de première couche de motif (5,28) sur le film mince (3), le dépôt de première couche de motif précédant ou succédant. à la gravure locale du film mince (3),
- une première étape de lithographie pour définir un emplacement (9, 31) de premier motif (11, 32), avec alignement de l'emplacement (9, 31) de premier motif par rapport à la première marque (8, 26),
- une gravure locale de la première couche de motif pour former un premier motif (11, 32),
- un dépôt d'une première couche de collage (13, 34) pour recouvrir la première marque (8, 26) et le premier motif (11, 32),
- un retournement de la structure obtenue suite au dépôt de la première couche de collage (13, 34),
- un collage de la première couche de collage (13, 34) sur un substrat de report (15),
- la suppression du substrat (1) et,
du côté du film mince (3) situé à l'opposé du substrat de report (15) :
- une étape de gravure de la première couche de collage (13, 34) pour former une deuxième marque (16) à l'emplacement de la première marque (8, 26),
- une étape de dépôt d'une deuxième couche de motif (18),
- une deuxième étape de lithographie pour définir un emplacement (20) de deuxième motif (22), avec alignement de l'emplacement (20) de deuxième motif par rapport à la deuxième marque (16), et
- une étape de gravure de la deuxième couche de motif (18) pour former le deuxième motif (22).

2. Procédé de formation de motifs selon la revendication 1, **caractérisé en ce que** le collage de la première couche de collage (13, 34) est effectué à l'aide d'une deuxième couche de collage (14) qui recouvre le substrat de report (15).

3. Procédé selon la revendication 2, **caractérisé en ce que**, les première (13, 34) et deuxième (14) couches de collage étant des couches d'oxyde, le collage est un collage moléculaire.

4. Procédé selon l'une quelconque des revendications précédentes, **caractérisé en ce que** la deuxième marque (16) est transférée dans le substrat de report (15).

5. Procédé selon l'une quelconque des revendications précédentes, **caractérisé en ce que** la gravure locale des première (5) et deuxième (18) couches de motif est une gravure plasma.

6. Procédé selon l'une quelconque des revendications précédentes, **caractérisé en ce que** la première (5) et la deuxième (18) couches de motif sont des couches de silicium poly-cristallin, ou de métal, ou de nitrure, ou de silicium, ou de silice, ou de matériau Hik.

7. Procédé selon l'une quelconque des revendications précédentes, **caractérisé en ce que** le film mince (3) est un film mince semi-conducteur.

8. procédé selon la revendication 7, **caractérisé en ce que** le film mince semi-conducteur est un film de silicium, d'arséniure de gallium ou de SiGe.

9. Procédé selon la revendication 7 ou 8,
**caractérisé en ce que** la gravure locale du film mince semi-conducteur (3) est une gravure chimique humide ou une gravure plasma anisotrope.

10. Procédé selon l'une quelconque des revendications 7 à 9, **caractérisé en ce qu'**il comprend une étape pour former une première couche d'oxyde de grille (4, 27) entre le film mince semi-conducteur (3) et la première couche de motif (5) et **en ce que** l'étape de dépôt de la deuxième couche de motif (18) est précédée du dépôt d'une deuxième couche d'oxyde de grille (17) sur le film mince semi-conducteur (3).

11. Procédé selon la revendication 10,
**caractérisé en ce que** le premier motif (11) et le deuxième motif (22) sont des grilles de transistor.

12. Procédé selon l'une quelconque des revendications 1 à 6, **caractérisé en ce que** le film mince (3) est un film mince métallique.

13. Procédé selon la revendication 12,
**caractérisé en ce que** le film mince métallique est un film de TiN ou de W.

14. Procédé selon l'une quelconque des revendications précédentes, **caractérisé en ce que** la première et la deuxième étapes de lithographie sont des étapes de lithographie optique ou électronique.

15. Procédé selon l'une quelconque des revendications précédentes, **caractérisé en ce qu'**il comprend la formation d'une couche tampon enterrée (2) entre le film mince (3) et le substrat (1).

16. Procédé selon la revendication 15,
**caractérisé en ce que** la couche tampon enterrée (2) est une couche de SiO₂, ou de SiGe, ou de Ni₃N₄.

## Claims

1. Method for forming aligned patterns (11, 22) on either side of a thin film (3) deposited on a substrate (1), the method comprising:
- local etching of the thin film (3) in order to form a first marking (8, 26),
- depositing a first pattern layer (5) on the thin film (3), depositing of the first pattern layer preceding or following local etching of the thin film (3) ,
- a first lithography step for defining a location (9, 31) of a first pattern (11, 32), with alignment of the first pattern location (9, 31) relatively to the first marking (8, 26),
- local etching of the first pattern layer in order to form a first pattern (11, 32),
- depositing a first bonding layer (13, 34) for covering the first marking (8, 26) and the first pattern (11, 32),
- turning over the obtained structure following the deposition of the first bonding layer (13, 34),
- suppressing the substrate (1), on the side of the thin film (3) opposite to the transfer substrate (15):
- a step for etching the first bonding layer (13, 25, 34) in order to form a second marking (16) at the location of the first marking (8, 26),
- a step for depositing a second pattern layer (18),
- a second lithography step for defining a location (20) of a second pattern (22), with alignment of the second pattern location (20) relatively to the second marking (16), and
- a step for etching the second pattern layer (18) in order to form the second pattern (22).

2. Method for forming patterns according to claim 1, **characterized in that** the bonding of the first bonding layer (13, 14) takes place with a second bonding layer (14) which covers the transfer substrate (15).

3. Method according to claim 2, **characterized in that**, as the first (13, 34) and second (14) bonding layers are oxide layers, bonding being a molecular bonding.

4. Method according to any of the preceding claims, **characterized in that** the second marking (16) is transferred into the transfer substrate (15).

5. Method according to any of the preceding claims, **characterized in that** the local etching of the first (5) and second (18) pattern layers is plasma etching.

6. Method according to any of the preceding claims, **characterized in that** the first (5) and the second (18) pattern layers are layers of polycrystalline silicon, or metal, or nitride or silicon, or silica, or HiK material.

7. Method according to any of the preceding claims, **characterized in that** the thin film (3) is thin semiconductor film.

8. Method according to claim 7, **characterized in that** the thin semiconductor film is a silicon, gallium arsenide, or SiGe film.

9. Method according to claim 7 or 8, **characterized in that** the local etching of the thin semiconductor film (3) is wet chemical etching or anisotropic plasma etching.

10. Method according to any of claims 7 to 9, **characterized in that** it comprises a step for forming a first gate oxide layer (4, 27) between the thin semiconductor film (3) and the first pattern layer (5) and **in that** the step for depositing the second pattern layer (18) is preceded by the deposition of a second gate oxide layer (17) on the thin semiconductor film (3).

11. Method according to claim 10, **characterized in that** the first pattern (11) and the second pattern (22) are transistor gates.

12. Method according to any of claims 1 to 6, **characterized in that** the thin film (3) is a thin metal film.

13. Method according to claim 12, **characterized in that** the thin metal film is TiN or W film.

14. Method according to any of the preceding claims, **characterized in that** the first and second lithography steps are optical or electronic lithography steps.

15. Method according to any of the preceding claims, **characterized in that** it comprises the formation of a buried buffer layer (2) between the thin film (3) and the substrate (1).

16. Method according to claim 15, **characterized in that** the buried buffer layer (20 is a SiO₂ or SiGe or Ni₃N₄ layer.

## Patentansprüche

1. Verfahren zur Herstellung von ausgerichteten Mustern (11, 22) auf beiden Seiten einer auf einem Substrat (1) abgeschiedenen Dünnschicht (3), wobei das Verfahren umfasst:
- eine lokale Ätzung der Dünnschicht (3), um eine erste Marke (8, 26) auszubilden,
- eine Abscheidung der ersten Musterschicht (5, 28) auf der Dünnschicht (3), wobei die Abscheidung der ersten Musterschicht der lokalen Ätzung der Dünnschicht (3) vorausgeht oder nachfolgt,
- einen ersten Lithographieschritt, um eine Stelle (9, 31) des ersten Musters (11, 32) zu definieren, mit Ausrichtung der Stelle (9, 31) des ersten Musters in Bezug auf die erste Marke (8, 26),
- eine lokale Ätzung der ersten Musterschicht, um ein erstes Muster (11, 32) auszubilden,
- ein Auftragen einer ersten Klebeschicht (13, 34), um die erste Marke (8, 26) und das erste Muster (11, 32) zu bedecken,
- ein Umkehren der nach der Auftragung der ersten Klebeschicht (13, 34) erhaltenen Struktur,
- ein Aufkleben der ersten Klebeschicht (13, 34) auf ein Übertragungssubstrat (15),
- das Beseitigen des Substrats (1), und
auf der dem Übertragungssubstrat (15) gegenüberliegenden Seite der Dünnschicht (3):
- einen Schritt zur Ätzung der ersten Klebeschicht (13, 34), um an der Stelle der ersten Marke (8, 26) eine zweite Marke (16) auszubilden,
- einen Schritt zur Abscheidung einer zweiten Musterschicht (18),
- einen zweiten Lithographieschritt, um eine Stelle (20) des zweiten Musters (22) zu definieren, mit Ausrichtung der Stelle (20) des zweiten Musters in Bezug auf die zweite Marke (16), und
- einen Schritt zur Ätzung der zweiten Musterschicht (18), um das zweite Muster (22) auszubilden.

2. Verfahren zur Herstellung von Mustern nach Anspruch 1, **dadurch gekennzeichnet, dass** die Klebung der ersten Klebeschicht (13, 34) mit Hilfe einer zweiten Klebeschicht (14) realisiert wird, die das Übertragungssubstrat (15) bedeckt.

3. Verfahren nach Anspruch 2, **dadurch gekennzeichnet, dass** die erste (13, 34) und zweite (14) Klebeschicht Oxidschichten sind und die Klebung eine Molekularklebung ist.

4. Verfahren nach einem der vorangehenden Ansprüche, **dadurch gekennzeichnet, dass** die zweite Marke (16) in das Übertragungssubstrat (15) transferiert wird.

5. Verfahren nach einem der vorangehenden Ansprüche, **dadurch gekennzeichnet, dass** die lokale Ätzung der ersten (5) und zweiten (18) Musterschicht eine Plasmaätzung ist.

6. Verfahren nach einem der vorangehenden Ansprüche, **dadurch gekennzeichnet, dass** die erste (5) und die zweite (18) Musterschicht Schichten aus polykristallinem Silicium oder Metall oder Nitrid oder Silicium oder Siliciumdioxid oder Material des Typs HiK bzw. mit hoher dielektrischer Konstante sind.

7. Verfahren nach einem der vorangehenden Ansprüche, **dadurch gekennzeichnet, dass** die Dünnschicht (3) eine Halbleiterdünnschicht ist.

8. Verfahren nach Anspruch 7, **dadurch gekennzeichnet, dass** die Halbleiterdünnschicht eine Dünnschicht aus Silicium, Galliumarsenid oder SiGe ist.

9. Verfahren nach Anspruch 7 oder 8, **dadurch gekennzeichnet, dass** die lokale Ätzung der Halbleiterdünnschicht (3) eine chemische Nassätzung oder eine anisotrope Plasmaätzung ist.

10. Verfahren nach einem der Ansprüche 7 bis 9, **dadurch gekennzeichnet, dass** es einen Schritt zur Bildung einer ersten Gateoxidschicht (4, 27) zwischen dem Halbleiterdünnfilm (3) und der ersten Musterschicht (5) umfasst, und dass dem Abscheidungsschritt der zweiten Musterschicht (18) die Abscheidung einer zweiten Gateoxidschicht (17) auf der Halbleiterdünnschicht (3) vorausgeht.

11. Verfahren nach Anspruch 10, **dadurch gekennzeichnet, dass** das erste Muster (11) und das zweite Muster (22) Transistorgates sind.

12. Verfahren nach einem der Ansprüche 1 bis 6, **dadurch gekennzeichnet, dass** die Dünnschicht (3) eine metallische Dünnschicht ist.

13. Verfahren nach Anspruch 12, **dadurch gekennzeichnet, dass** die metallische Dünnschicht eine TiN- oder W-Schicht ist.

14. Verfahren nach einem der vorangehenden Ansprüche, **dadurch gekennzeichnet, dass** der erste und der zweite Lithographieschritt optische oder elektronische Lithographieschritte sind.

15. Verfahren nach einem der vorangehenden Ansprüche, **dadurch gekennzeichnet, dass** es die Bildung einer vergrabenen Pufferschicht (2) zwischen der Dünnschicht (3) und dem Substrat (1) umfasst.

16. Verfahren nach Anspruch 15, **dadurch gekennzeichnet, dass** die vergrabene Pufferschicht (2) eine SiO₂- oder SiGe- oder Ni₃N₄-Schicht ist.
